# EUROPÄISCHE PATENTSCHRIFT

(11) **EP 1 886 360 B1**
(45) Veröffentlichungstag und Bekanntmachung des Hinweises auf die Patenterteilung: **22.08.2018**
(21) Anmeldenummer: 06742397.0
(22) Anmeldetag: 02.06.2006
(51) Int. Cl.: H01L 33/38

(54) **LUMINESZENZDIODENCHIP MIT EINER KONTAKTSTRUKTUR**
LIGHT-EMITTING DIODE CHIP COMPRISING A CONTACT STRUCTURE
PUCE DE DIODE ELECTROLUMINESCENTE A STRUCTURE DE CONTACT

(30) Priorität: 02.06.2005 DE 102005025416
(43) Veröffentlichungstag der Anmeldung: 13.02.2008
(73) Patentinhaber: OSRAM Opto Semiconductors GmbH, 93055 Regensburg (DE)
(72) Erfinder: HÄRLE, Volker, 93164 Laaber (DE); HAHN, Berthold, 93155 Hemau (DE); BAUR, Johannes, 93051 Regensburg (DE); OBERSCHMID, Raimund, 93161 Sinzing (DE); WEIMAR, Andreas, 93055 Regensburg (DE); GUENTHER, Ewald Karl Michael, 93128 Regenstauf (DE); EBERHARD, Franz, 93059 Regensburg (DE); RICHTER, Markus, 93133 Burglengenfeld (DE); STRAUSS, Jörg, 93051 Regensburg (DE)
(74) Vertreter: Epping - Hermann - Fischer
(86) Internationale Anmeldenummer: PCT/DE2006/000954
(87) Internationale Veröffentlichungsnummer: WO 2006/128446

(56) Entgegenhaltungen:
- EP-A- 1 383 177
- EP-A- 1 406 314
- DE-A1-102005 003 460
- JP-A- 2000 091 638
- JP-A- 2003 133 589
- JP-A- 2004 363 572
- JP-A- 2005 012 092
- JP-A- 2005 019 653
- US-A1- 2003 102 484

## Beschreibung

Die Erfindung betrifft einen Lumineszenzdiodenchip nach dem Oberbegriff des Patentanspruchs 1.

Bei Lumineszenzdiodenchips, die mittels eines Bonddrahts elektrisch kontaktiert sind, ist in der Regel ein vergleichsweise kleiner zentraler Bereich der Chipoberfläche mit einer Kontaktfläche (Bondpad) zum Anschluss des Bonddrahts versehen. Da Lumineszenzdiodenchips in der Regel mit einer dem Bonddraht gegenüber liegenden Chipoberfläche auf einen Träger oder in ein LED-Gehäuse montiert werden, ist die Chipoberfläche, auf der das Bondpad angeordnet ist, die Strahlungsaustrittsfläche, also die Chipoberfläche, aus der zumindest der überwiegende Teil der in einer aktiven Zone des Lumineszenzdiodenchips erzeugten elektromagnetischen Strahlung aus dem Lumineszenzdiodenchip ausgekoppelt wird.

Bei herkömmlichen Lumineszenzdiodenchips, die eine Kantenlänge von weniger als 300 µm aufweisen, kann mit einem zentral auf der Strahlungsauskoppelfläche angeordneten Bondpad eine vergleichsweise homogene Stromverteilung im Lumineszenzdiodenchip erreicht werden. Bei großflächigen Lumineszenzdiodenchips, die zum Beispiel eine Kantenlänge von bis zu 1 mm aufweisen, kann diese Art der Kontaktierung aber nachteilig zu einer inhomogenen Bestromung des Lumineszenzdiodenchips führen, die zu einer erhöhten Vorwärtsspannung und zu einer geringen Quanteneffizienz in der aktiven Zone führt. Dieser Effekt tritt insbesondere bei Halbleitermaterialien, die eine geringe Querleitfähigkeit aufweisen, beispielsweise bei Nitridverbindungshalbleitern, auf. Die maximale Stromdichte tritt in diesem Fall in einem zentralen Bereich des Lumineszenzdiodenchips auf und verringert sich ausgehend von dem zentralen Bondpad in Richtung der Seitenflanken mit zunehmendem Abstand vom Bondpad. Dies hat eine oftmals unerwünschte ungleichmäßige Helligkeit der Strahlungsaustrittsfläche zur Folge. Weiterhin ist es nachteilig, dass die in dem zentralen Bereich des Lumineszenzdiodenchips emittierte Strahlung, in dem die größte Stromdichte auftritt, zumindest teilweise zu dem nicht transparenten Bondpad hin emittiert und somit zumindest teilweise absorbiert wird.

Aus der DE 199 47 030 A1 ist bekannt, die

Strahlungsauskoppelfläche einer InGaAlP-LED mit einer Kontaktstruktur zu versehen, die ein zentrales Bondpad und mehrere mit dem Bondpad verbundene Kontaktstege umfasst, um eine bessere Stromaufweitung zu erzielen.

Die Druckschriften US 2003/0102484 A1, JP 2000-091638 A, JP 2003-133589 A, DE 102005003460 A1 und EP 1406314 A1 beschreiben jeweils Nitridverbindungshalbleiter-Leuchtdiodenchips, die an einer Strahlungsaustrittsfläche ein Bondpad und vom Bondpad ausgehende Kontaktstege aufweisen.

Der Erfindung liegt die Aufgabe zugrunde, einen Lumineszenzdiodenchip mit einer auf der Strahlungsaustrittsfläche angeordneten verbesserten Kontaktstruktur anzugeben, die sich insbesondere durch eine verminderte Absorption von Strahlung sowie eine homogene Stromeinprägung auszeichnet.

Diese Aufgabe wird durch einen Lumineszenzdiodenchip nach dem Oberbegriff des Patentanspruchs 1 gelöst. Vorteilhafte Ausgestaltungen und Weiterbildungen der Erfindung sind Gegenstand der abhängigen Ansprüche.

Bei einem erfindungsgemäßen Lumineszenzdiodenchip mit einer Strahlungsaustrittsfläche und einer Kontaktstruktur, die auf der Strahlungsaustrittsfläche angeordnet ist und ein Bondpad und mehrere zur Stromaufweitung vorgesehene Kontaktstege, die mit dem Bondpad elektrisch leitend verbunden sind, umfasst, weist der Mittelpunkt des Bondpads einen geringeren Abstand zu zumindest einer Seitenflanke des Lumineszenzdiodenchips als zum Mittelpunkt der Strahlungsaustrittsfläche auf. Der Lumineszenzdiodenchip enthält eine Halbleiterschichtenfolge, die eine aktive Schicht umfasst. Zumindest einer der Kontaktstege weist eine variable Breite auf, wobei die Breite des Kontaktstegs in seiner Haupterstreckungsrichtung ausgehend vom Bondpad schrittweise oder kontinuierlich zunimmt, und wobei weniger als 15% der Strahlungsaustrittsfläche von der Kontaktstruktur bedeckt sind.

Durch die Anordnung des Bondpads in einem Randbereich der Strahlungsaustrittsfläche wird die durch einen zentralen Bereich der Strahlungsaustrittsfläche aus dem Lumineszenzdiodenchip austretende Strahlung vorteilhaft nicht in dem Bondpad absorbiert. Die Anordnung des Bondpads in einem Randbereich der Strahlungsaustrittsfläche ist so zu verstehen, dass der Mittelpunkt des Bondpads einen geringeren Abstand zu zumindest einer Seitenflanke des Lumineszenzdiodenchips als zum Mittelpunkt der Strahlungsaustrittsfläche aufweist. Vorteilhaft ist es durch die Anordnung des Bondpads in einem Randbereich der Strahlungsaustrittsfläche im Gegensatz zu einem Lumineszenzdiodenchip mit einem zentral auf der Strahlungsaustrittsfläche angeordneten Bondpad nicht erforderlich, einen Bonddraht über die Strahlungsaustrittsfläche zu dem Bondpad hinzuführen. Dies ist insbesondere vorteilhaft für Lumineszenzdiodenchips, die mit vergleichsweise hohen Stromstärken, zum Beispiel mehr als 300 mA, betrieben werden, da bei einem Betrieb mit derart hohen Stromstärken ein vergleichsweise dicker Bonddraht erforderlich ist, in dem bei einer Anordnung oberhalb der Strahlungsaustrittsfläche eine nicht vernachlässigbare Absorption der emittierten Strahlung auftreten würde. Dadurch, dass auf der Strahlungsaustrittsfläche mehrere mit dem Bondpad elektrisch leitend verbundene Kontaktstege angeordnet sind, kann trotz des in einen Randbereich der Strahlungsaustrittsfläche angeordneten Bondpads eine vergleichsweise homogene Stromverteilung in dem Lumineszenzdiodenchip erreicht werden.

Der Abstand zwischen dem Bondpad und zumindest einer Seitenflanke des Lumineszenzdiodenchips ist vorzugsweise geringer als 30 µm. Insbesondere kann das Bondpad auch direkt an eine Seitenflanke des Lumineszenzdiodenchips angrenzen.

Vorteilhaft ist das Bondpad derart an einer Ecke der Strahlungsaustrittsfläche angeordnet, dass sowohl der Abstand zwischen dem Bondpad und einer ersten Seitenflanke des Lumineszenzdiodenchips als auch der Abstand zwischen dem Bondpad und einer zweiten Seitenflanke des Lumineszenzdiodenchips jeweils geringer ist als 30 µm. Insbesondere kann das Bondpad sowohl an die erste Seitenflanke als auch an die zweite Seitenflanke des Lumineszenzdiodenchips angrenzen.

Bei einer bevorzugten Variante verläuft mindestens ein Kontaktsteg entlang einer Seitenkante des Lumineszenzdiodenchips, wobei der Abstand zur Seitenkante geringer ist als 15pm. Insbesondere kann der Kontaktsteg an die Seitenkante angrenzen. Die geringe Beabstandung zur Seitenkante ist bei einem Lumineszenzdiodenchip, der auf der Strahlungsaustrittsfläche eine Lumineszenzkonversionsschicht aufweist, von Vorteil. Da der Randbereich von der Konversionsschicht unbedeckt bleiben soll, um beispielsweise Chipbeschädigungen während der Herstellung erkennen zu können, kann der Randbereich mittels der Anordnung des Kontaktstegs mit Vorteil zur Stromaufweitung genutzt werden.

Die Kontaktstege sind vorteilhaft derart auf der Strahlungsaustrittsfläche angeordnet, dass eine aktive Schicht des Lumineszenzdiodenchips derart homogen von einem Strom durchflossen wird, dass die Strahlungsaustrittsfläche des Lumineszenzdiodenchips eine gleichmäßige Helligkeit aufweist. Insbesondere ist vorgesehen, dass die Kontaktstege auf der Strahlungsaustrittsfläche einen Umriss zumindest eines Rechtecks oder zumindest eines Quadrats ausbilden.

Bei einer weiteren vorteilhaften Ausgestaltung der Erfindung ist auf einen von den Kontaktstegen umschlossenen Teilbereich der Strahlungsaustrittsfläche eine Lumineszenzkonversionsschicht aufgebracht. Die Lumineszenzkonversionsschicht enthält zumindest einen Lumineszenzkonversionsstoff, der zur Wellenlängenkonversion zumindest eines Teils der von dem Lumineszenzdiodenchip emittierten Strahlung zu größeren Wellenlängen hin geeignet ist. Auf diese Weise kann insbesondere mit einem Lumineszenzdiodenchip, der ultraviolette oder blaue Strahlung emittiert, durch Wellenlängenkonversion eines Teil der emittierten Strahlung in den komplementären Spektralbereich, beispielsweise den gelben Spektralbereich, Weißlicht erzeugt werden. Der Lumineszenzkonversionsstoff kann in Form eines feinkörnigen Pulvers vorliegen, dessen Partikel typischerweise eine Korngröße im Bereich von 1µm bis 20µm aufweisen. Unter der Korngröße ist vorliegend der mittlere Durchmesser eines Pulverpartikels zu verstehen. Geeignete Lumineszenzkonversionsstoffe, wie zum Beispiel YAG:Ce, sind aus der WO 98/12757 bekannt, deren Inhalt hiermit insbesondere in Bezug auf Leuchtstoffe durch Referenz aufgenommen wird. Die Lumineszenzkonversionsschicht ist vorteilhaft eine Kunststoffschicht, bevorzugt eine Silikonschicht, in die der zumindest eine Lumineszenzkonversionsstoff matrixartig eingebettet ist. Vorzugsweise beträgt die Dicke der Lumineszenzkonversionsschicht 10µm bis 50µm. Die Lumineszenzkonversionsschicht ist vorteilhaft mit einem Siebdruckverfahren auf die Strahlungsaustrittsfläche des Lumineszenzdiodenchips aufgebracht. Eine mittels des Siebdruckverfahrens erzielbare Justage- beziehungsweise Strukturierungsgenauigkeit beträgt etwa 20µm.

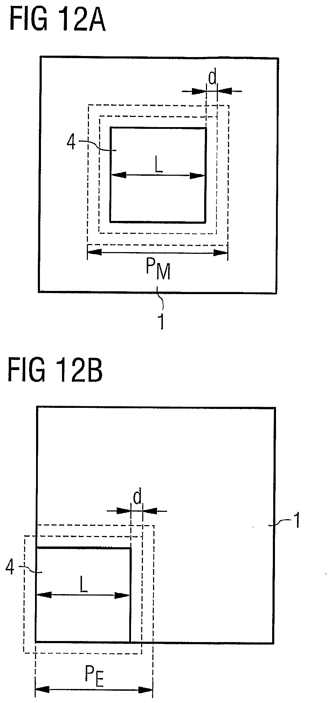

Die Anforderungen an die Justage- beziehungsweise Strukturierungsgenauigkeit sind bei einem Chip mit Anordnung des Bondpads in einer Ecke vorteilhaft verringert gegenüber einem Chip mit zentraler Anordnung des Bondpads, wie nachfolgend im Zusammenhang mit den Figuren 12A und 12B näher erläutert wird. Ferner kann die optisch nutzbare Fläche erhöht werden.

Ein weiterer Vorteil einer Eck-Anordnung des Bondpads in Kombination mit einer Lumineszenzkonversionsschicht auf der Strahlungsaustrittsfläche besteht bei einer Anordnung aus mehreren Chips im Waferverbund. Vorzugsweise sind hierbei die Bondpads einander zugewandt, so dass eine zusammenhängende von der Lumineszenzkonversionsschicht unbedeckte Fläche gebildet wird, die größer ist als bei einem einzelnen zentral angeordneten Bondpad. Dies ist für die Strukturierung vorteilhaft und ermöglicht eine reproduzierbare Schichtherstellung.

Bei einer weiteren bevorzugten Ausführungsform ist die Lumineszenzkonversionsschicht von den Seitenflanken des Lumineszenzdiodenchips beabstandet. Insbesondere kann vorgesehen sein, dass die Lumineszenzkonversionsschicht innerhalb eines von den Kontaktstegen umschlossenen Teilbereichs der Strahlungsaustrittsfläche angeordnet ist. Die auf der Strahlungsaustrittsfläche angeordneten Kontaktstege bilden in diesem Fall einen Rahmen für die Lumineszenzkonversionsschicht. Auf diese Weise wird vorteilhaft die Gefahr vermindert, dass das Material der Lumineszenzkonversionsschicht an die Seitenflanken des Lumineszenzdiodenchips gelangt. Dies ist insbesondere dann vorteilhaft, wenn eine mikroskopische Untersuchung der Seitenflanke des Lumineszenzdiodenchips zur Qualitätskontrolle vorgesehen ist. Eine derartige Qualitätskontrolle würde durch auf der Seitenflanke des Lumineszenzdiodenchips abgelagertes Material der Lumineszenzkonversionsschicht erschwert oder sogar unmöglich gemacht.

Gemäß einer weiteren Variante ist die Kontaktstruktur gabelförmig ausgebildet. Hierbei verlaufen mehrere Kontaktstege quer zu einem Kontaktsteg und im Wesentlichen parallel zueinander. Vorzugsweise ist zwischen den Kontaktstegen eine Lumineszenzkonversionsschicht auf der Strahlungsaustrittsfläche aufgebracht.

Zumindest einer der Kontaktstege weist eine variable Breite auf. Unter der Breite des Kontaktstegs ist die Abmessung des Kontaktstegs in einer senkrecht zu seiner Längsrichtung und parallel zur Ebene der Strahlungsaustrittsfläche verlaufenden Richtung zu verstehen. Insbesondere kann vorgesehen sein, dass der Kontaktsteg mit variabler Breite mehrere Teilbereiche mit verschiedener Breite enthält. In diesem Fall ist die Breite der Teilbereiche des Kontaktsteges vorteilhaft an eine beim Betrieb des Lumineszenzdiodenchips durch den jeweiligen Teilbereich des Kontaktstegs auftretende Stromstärke angepasst. Die Breite der Teilbereiche ist beispielsweise derart an die im jeweiligen Teilbereich auftretende Stromstärke angepasst, dass die Stromdichte in dem jeweiligen Teilbereich einen Grenzwert, zum Beispiel 16 A/µm² nicht überschreitet. Weiterhin sind die Breiten der Teilbereiche des Kontaktstegs mit variabler Breite und/oder die Breiten der weiteren Kontaktstege bevorzugt derart dimensioniert, dass eine Mindeststromdichte nicht unterschritten wird. Auf diese Weise wird vorteilhaft erreicht, dass die Breite der Kontaktstege und/oder der Teilbereiche des Kontaktstegs mit variabler Breite zumindest nicht wesentlich größer ist, als es für die Stromtragfähigkeit erforderlich ist. Dies hat den Vorteil, dass der von den Kontaktstegen bedeckte Teilbereich der Strahlungsaustrittsfläche vorteilhaft gering ist und somit die Absorption der von dem Lumineszenzdiodenchip erzeugten Strahlung in den auf der Strahlungsaustrittsfläche angeordneten Kontaktstegen vermindert wird.

Die Stromverteilung im Chip kann durch eine laterale Stromverteilung und eine vertikale Stromverteilung unterschieden werden. Unter der lateralen Stromverteilung ist vorliegend die Stromverteilung parallel zur Strahlungsaustrittsfläche zu verstehen, während mit der vertikalen Stromverteilung der vertikale Stromfluss quer, vorzugsweise senkrecht, zur Strahlungsaustrittsfläche gemeint ist.

Im Chip bestehen ausgehend von einer Stromeinspeisungsstelle, etwa dem Bondpad, verschiedene Strompfade. Ein lateraler Hauptstrompfad verläuft entlang des Kontaktstegs. Dieser Hauptstrompfad verzweigt sich in vertikaler Richtung in mehrere Nebenstrompfade. Die Strompfade können in einer Ersatzschaltung als eine Serienschaltung von Widerständen dargestellt werden. Bei einer bevorzugten Ausgestaltung ist der Kontaktsteg derart strukturiert, dass der Gesamtwiderstand entlang der verschiedenen Strompfade möglichst gleich ist. Vorteilhafterweise kann der Chip dadurch vergleichsweise homogen bestromt werden.

Bei dem Lumineszenzdiodenchip nimmt die Breite des Kontaktstegs mit zunehmendem Abstand vom Bondpad zu. Insbesondere kann der Kontaktsteg mehrere Teilbereiche aufweisen, wobei der Teilbereich mit größerem Abstand zum Bondpad breiter ist als der Teilbereich mit geringerem Abstand zum Bondpad. Alternativ kann die Breite des Kontaktstegs ausgehend vom Bondpad kontinuierlich zunehmen.

Die Breite der Kontaktstege beträgt bevorzugt zwischen einschließlich 10 µm und einschließlich 40 µm.

Bei einer weiteren vorteilhaften Ausgestaltung ist der Lumineszenzdiodenchip ein Dünnfilm-Lumineszenzdiodenchip. Bei der Herstellung eines Dünnfilm-Lumineszenzdiodenchips wird eine funktionelle Halbleiterschichtenfolge, die insbesondere eine strahlungsemittierende aktive Schicht umfasst, zunächst epitaktisch auf einem Aufwachssubstrat aufgewachsen, anschließend ein neuer Träger auf die dem Aufwachssubstrat gegenüber liegende Oberfläche der Halbleiterschichtenfolge aufgebracht und nachfolgend das Aufwachssubstrat abgetrennt. Da insbesondere die für Nitridverbindungshalbleiter verwendeten Aufwachssubstrate, beispielsweise SiC, Saphir oder GaN vergleichsweise teuer sind, bietet dieses Verfahren insbesondere den Vorteil, dass das Aufwachssubstrat wiederverwertbar ist. Das Ablösen eines Aufwachssubstrats aus Saphir von einer Halbleiterschichtenfolge aus einem Nitridverbindungshalbleiter kann beispielsweise mit einem aus der WO 98/14986 bekanntem Laser-Lift-Off-Verfahren erfolgen.

Ein Grundprinzip einer Dünnfilm-LED ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Insbesondere kann der Lumineszenzdiodenchip eine Epitaxie-Schichtenfolge aufweisen, die auf Nitridverbindungshalbleitern basiert. "Auf NitridVerbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₓGa_{y}In_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₓGa_{y}In_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die Strahlungsaustrittsfläche kann insbesondere eine quadratische Form aufweisen. Bei einer Ausführungsform des Lumineszenzdiodenchips beträgt zumindest eine Kantenlänge der Strahlungsaustrittsfläche 400 µm oder mehr, besonders bevorzugt 800 µm oder mehr. Insbesondere kann sogar eine Kantenlänge vom 1 mm oder mehr vorgesehen sein. Aufgrund der der Stromaufweitung durch die auf der Strahlungsaustrittsfläche angeordneten Kontaktstege kann selbst bei derart großflächigen Lumineszenzdiodenchips eine vergleichsweise homogene Stromverteilung in der aktiven Schicht erzielt werden.

Besonders vorteilhaft ist die aus dem Bondpad und den Kontaktstegen gebildete Kontaktstruktur für Lumineszenzdiodenchips, die mit einer Stromstärke von 300 mA oder mehr betrieben werden, da bei derart hohen Betriebsstromstärken bei herkömmlichen Lumineszenzdiodenchips eine inhomogene Stromverteilung, die ein Maximum in einem zentralen, mit dem Bondpad versehenen Bereich des Lumineszenzdiodenchips aufweisen würde, zu beobachten wäre.

Die Kontaktstruktur enthält vorzugsweise ein Metall oder eine Metalllegierung. Vorzugsweise ist die Kontaktstruktur eine strukturierte Ti-Pt-Au-Schichtenfolge, die ausgehend von einer angrenzenden Halbleiterschicht des Lumineszenzdiodenchips zum Beispiel eine etwa 50 nm dicke Ti-Schicht, eine etwa 50 nm dicke Pt-Schicht und eine etwa 2 µm dicke Au-Schicht umfasst. Eine Ti-Pt-Au-Schichtenfolge ist vorteilhaft unempfindlich gegenüber Elektromigration, die ansonsten, beispielsweise bei einer Aluminium enthaltenden Kontaktstruktur, auftreten könnte. Die Kontaktstruktur ist daher bevorzugt frei von Aluminium.

Ferner kann die Kontaktstruktur, insbesondere die Ti-Schicht, derart ausgebildet sein, dass die vom Chip erzeugte Strahlung absorbiert wird. Dadurch ist es möglich, Wellenleitereffekte zu reduzieren, die zur Emission von Strahlung außerhalb der von der Konversionsschicht bedeckten Bereiche führen.

Bei dem Lumineszenzdiodenchip sind nur weniger als 15%, besonders bevorzugt weniger als 10% der Strahlungsaustrittsfläche von der Kontaktstruktur bedeckt. Die Absorptionsverluste innerhalb der Kontaktstruktur sind dadurch vorteilhaft gering.

Bei einer weiteren bevorzugten Ausführungsform enthält der Lumineszenzdiodenchip eine Halbleiterschichtenfolge mit einer aktiven Schicht, wobei an einer der Strahlungsaustrittsfläche gegenüberliegenden Hauptfläche der Halbleiterschichtenfolge eine reflektierende Kontaktschicht vorgesehen ist. Ein dem Bondpad gegenüberliegender Bereich der Hauptfläche ist vorteilhaft von der reflektierenden Kontaktschicht ausgespart.

Die von der aktiven Schicht aus gesehen der Strahlungsaustrittsfläche gegenüber liegende Kontaktschicht ist also derart strukturiert, dass in vertikaler Richtung dem Bondpad von der aktiven Schicht aus gesehen ein nicht von der Kontaktschicht bedeckter Bereich der Hauptfläche gegenüber liegt. Dies hat den Vorteil, dass die Stromdichte in einem Bereich der aktiven Schicht, der in vertikaler Richtung unterhalb des Bondpads liegt, vermindert ist, so dass weniger Strahlung unterhalb des Bondpads erzeugt wird. Weiterhin wird durch die Aussparung der reflektierenden Kontaktschicht der Anteil der emittierten Strahlung, der von der reflektierenden Kontaktschicht in Richtung des Bondpads reflektiert wird, vermindert. Auf diese Weise wird die Absorption von Strahlung in dem Bondpad vermindert. Die Effizienz des Lumineszenzdiodenchips wird dadurch vorteilhaft erhöht.

Wenn die Strahlungsaustrittsfläche des Lumineszenzdiodenchips, wie zuvor beschrieben, teilweise mit einer Lumineszenzkonversionsschicht versehen ist, ist vorteilhaft ein von der aktiven Schicht aus gesehen der Lumineszenzkonversionsschicht gegenüberliegender Bereich der Hauptfläche der Halbleiterschichtenfolge, die der Kontaktstruktur gegenüberliegt, von der reflektierenden Kontaktschicht ausgespart. Auf diese Weise wird die Erzeugung von Strahlung in den Bereichen der aktiven Schicht, die in lateraler Richtung versetzt zu der auf der Strahlungsaustrittsfläche angeordneten Lumineszenzkonversionsschicht angeordnet sind, vermindert. Weiterhin wird so der Anteil der emittierten Strahlung, der von der reflektierenden Kontaktschicht in den nicht mit der Lumineszenzkonversionsschicht versehenen Teilbereich der Strahlungsaustrittsfläche reflektiert wird, vermindert.

Bei einem Chip, der kurzwellige Strahlung emittiert, wird vorzugsweise Ag für die reflektierende Kontaktschicht verwendet. Hierbei kann es insbesondere bei einer Beschädigung des Chiprandes und eindringender Feuchtigkeit zu Elektromigration kommen. Die Elektromigration kann zu Nebenschlüssen führen, die die Alterungsstabilität des Chips nachteilig beeinflussen. Bei der Erfindung wird einer derartigen Beschädigung mittels einer Beabstandung der Kontaktschicht von der Seitenkante entgegengewirkt.

Der Lumineszenzdiodenchip wird im folgenden anhand eines erfindungsgemäßen Ausführungsbeispiels (Figur 10) und weiteren nicht erfindungsgemäßen Beispielen (Figuren 1 bis 9, 11 und 12) näher erläutert.

Es zeigen:
- Figur 1A: eine schematische Darstellung einer Aufsicht auf einen Lumineszenzdiodenchip gemäß einem ersten Beispiel,
- Figur 1B: eine schematische Darstellung eines Querschnitts entlang der Linie AB des in Figur 1A dargestellten Beispiels,
- Figur 2: eine schematische Darstellung einer Aufsicht auf die Strahlungsaustrittsfläche eines Lumineszenzdiodenchips gemäß einem zweiten Beispiel,
- Figur 3: eine schematische Darstellung einer Aufsicht auf die Strahlungsaustrittsfläche eines Lumineszenzdiodenchips gemäß einem dritten Beispiel,
- Figur 4: eine schematische Darstellung einer Aufsicht auf die Strahlungsaustrittsfläche eines Lumineszenzdiodenchips gemäß einem vierten Beispiel,
- Figur 5: eine schematische Darstellung einer Aufsicht auf die Strahlungsaustrittsfläche eines Lumineszenzdiodenchips gemäß einem fünften Beispiel,
- Figur 6: eine schematische Darstellung einer Aufsicht auf die Strahlungsaustrittsfläche eines Lumineszenzdiodenchips gemäß einem sechsten Beispiel,
- Figur 7: eine schematische Darstellung einer Aufsicht auf die Strahlungsaustrittsfläche eines Lumineszenzdiodenchips gemäß einem siebten Beispiel,
- Figur 8: eine schematische Darstellung einer Aufsicht auf die Strahlungsaustrittsfläche eines Lumineszenzdiodenchips gemäß einem achten Beispiel,
- Figur 9: ein Ersatzschaltbild eines Ausschnitts aus einem Lumineszenzdiodenchip,
- Figur 10: eine schematische Darstellung einer Aufsicht auf die Strahlungsaustrittsfläche eines Lumineszenzdiodenchips gemäß einem Ausführungsbeispiel der Erfindung,
- Figur 11: eine schematische Darstellung einer Aufsicht auf die Strahlungsaustrittsfläche eines Lumineszenzdiodenchips gemäß einem neunten Beispiel,
- Figur 12A: eine schematische Darstellung einer zentralen Anordnung des Bondpads,
- Figur 12B: eine schematische Darstellung einer Eck-Anordnung des Bondpads.

Gleiche oder gleichwirkende Elemente sind in den Figuren mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

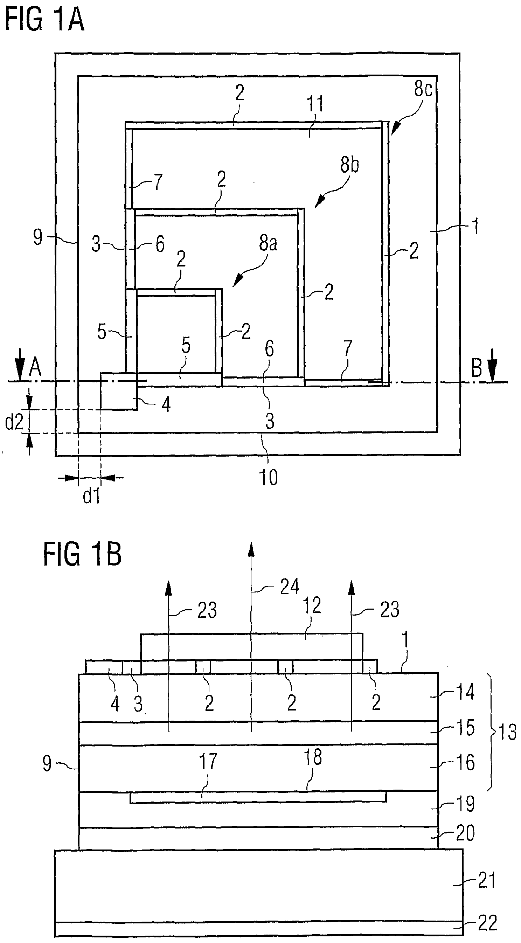

Ein erstes Beispiel eines Lumineszenzdiodenchips ist in Figur 1A in einer Aufsicht und in Figur 1B im Querschnitt schematisch dargestellt. Der Lumineszenzdiodenchip enthält eine Halbleiterschichtenfolge 13, die beispielsweise epitaktisch, bevorzugt mittels MOVPE, hergestellt ist. Die Halbleiterschichtenfolge 13 enthält eine strahlungsemittierende aktive Schicht 15.

Die aktive Schicht 15 des Lumineszenzdiodenchips umfasst beispielsweise InₓAl_{y}Ga_{1-x-y}N mit 0 ≤ x ≤ 1, 0 ≤ y ≤ 1 und x + y ≤ 1. Die aktive Schicht 15 kann zum Beispiel als Heterostruktur, Doppelheterostruktur oder als Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Aus der aktiven Schicht 15 wird elektromagnetische Strahlung 23, beispielsweise Strahlung im ultravioletten, blauen oder grünen Spektralbereich, in eine Hauptstrahlungsrichtung 24 emittiert. Die aktive Schicht 15 ist zum Beispiel zwischen mindestens einer n-leitenden Halbleiterschicht 14 und mindestens einer p-leitenden Halbleiterschicht 16 angeordnet. Die aus der aktiven Schicht 15 emittierte Strahlung 23 wird an einer Strahlungsaustrittsfläche 1 aus dem Lumineszenzdiodenchip ausgekoppelt.

Zur Stromeinprägung in die aktive Schicht 15 ist auf der Strahlungsaustrittsfläche 1 eine Kontaktstruktur 2, 3, 4 vorgesehen. Die Kontaktstruktur 2, 3, 4 auf der Strahlungsaustrittsfläche 1 wird durch ein Bondpad 4 und mehrere Kontaktstege 2, 3, die mit dem Bondpad 4 elektrisch leitend verbunden sind, ausgebildet. Die Kontaktstruktur 2, 3, 4 enthält vorzugsweise ein Metall oder eine Metalllegierung. Insbesondere kann die Kontaktstruktur 2, 3, 4 aus einer strukturierten Ti-Pt-Au-Schichtenfolge (nicht dargestellt) gebildet sein. Zur Strukturierung können die dem Fachmann bekannten Strukturierungsverfahren, insbesondere das Aufbringen einer Maske in Verbindung mit einem nachfolgenden Ätzprozess, eingesetzt werden. Die Ti-Pt-Au-Schichtenfolge, aus der die Kontaktstruktur 2, 3, 4 vorzugsweise hergestellt ist, enthält beispielsweise eine etwa 50 nm dicke Ti-Schicht, eine etwa 50 nm dicke Pt-Schicht und eine etwa 2 µm dicke Au-Schicht. Eine derartige Ti-Pt-Au-Schichtenfolge ist vorteilhaft unempfindlich gegenüber Elektromigration, die ansonsten, beispielsweise bei einer Aluminium enthaltenden Kontaktstruktur, auftreten könnte. Die Kontaktstruktur ist aus diesem Grund bevorzugt frei von Aluminium.

Bei dem Lumineszenzdiodenchip handelt es sich vorzugsweise um einen Dünnfilm-Lumineszenzdiodenchip. Die Halbleiterschichtenfolge 13 ist zum Beispiel auf einem Aufwachssubstrat hergestellt worden, das ursprünglich an einer der Strahlungsaustrittsfläche 1 zugewandten Oberfläche der Halbleiterschichtenfolge 13 angeordnet war und nachfolgend, beispielsweise mit einem aus der WO 98/14986 bekanntem Laser-Lift-Off-Verfahren, abgelöst wurde. An einer der Strahlungsaustrittsfläche 1 und somit dem ursprünglichen Aufwachssubstrat gegenüber liegenden Seite der aktiven Schicht 15 ist die Halbleiterschichtenfolge 13 auf einem Träger 21 befestigt. Beispielsweise ist die Halbleiterschichtenfolge 13 mittels einer Verbindungsschicht 20, die insbesondere eine Lotschicht sein kann, auf dem Träger 21 befestigt. Der Träger 21 ist beispielsweise eine Leiterplatte, insbesondere eine gedruckte Leiterplatte (Printed Circuit Board). Ferner kann der Träger 21 aus einer Keramik, die insbesondere Aluminiumnitrid enthalten kann, gebildet sein. Auch Träger aus einem Halbleitermaterial, wie beispielsweise Ge- oder GaAs-Träger, können verwendet werden. Eine von der Halbleiterschichtenfolge 13 abgewandte Rückseite des Trägers 21 ist zum Beispiel mit einer elektrischen Kontaktschicht 22 versehen, die einen der Kontaktstruktur 2, 3, 4 von der aktiven Schicht 15 aus gesehen gegenüber liegenden zweiten elektrischen Kontakt des Lumineszenzdiodenchips ausbildet.

Das Bondpad 4 der auf der Strahlungsaustrittsfläche 1 angeordneten Kontaktstruktur ist in einem Randbereich der Strahlungsaustrittsfläche 1 angeordnet. Bevorzugt ist der Abstand d₁ zwischen einer Seitenflanke 9 des Lumineszenzdiodenchips und dem Bondpad 4 geringer als 30 µm. Besonders bevorzugt ist das Bondpad 4, wie in der in Figur 1 dargestellten Aufsicht zu erkennen ist, im Bereich einer Ecke der Strahlungsaustrittsfläche 1 angeordnet. In diesem Fall beträgt der Abstand d₁ des Bondpads 4 zu einer ersten Seitenflanke 9 des Lumineszenzdiodenchips und der Abstand d₂ zu einer zweiten Seitenflanke 10 des Lumineszenzdiodenchips vorzugsweise jeweils 30 µm oder weniger. Eine derartige Anordnung des Bondpads in einem Randbereich der Strahlungsaustrittsfläche 1 hat den Vorteil, dass eine Absorption der in der aktiven Schicht 15 erzeugten elektromagnetischen Strahlung 23 in dem Bondpad 4 vermindert wird.

Um trotz der Anordnung des Bondpads 4 in einem Randbereich der Strahlungsaustrittsfläche 1 eine in lateraler Richtung homogene Stromverteilung in der aktiven Schicht 15 zu erzielen, sind mehrere Kontaktstege 2, 3, die jeweils mit dem Bondpad 4 elektrisch leitend verbunden sind, auf der Strahlungsaustrittsfläche 1 angeordnet. Beispielsweise sind, wie in der Aufsicht in Figur 1A zu erkennen ist, mehrere Kontaktstege 2, 3 derart auf der Strahlungsaustrittsfläche 1 angeordnet, dass sie den Umriss mehrerer Quadrate 8a, 8b, 8c ausbilden. Die von den Kontaktstegen 2, 3 ausgebildeten Quadrate 8a, 8b, 8c weisen vorteilhaft jeweils zwei gemeinsame Seitenkanten auf, die jeweils durch einen Kontaktsteg 3 gebildet werden. Das Bondpad 4 ist dabei in einem gemeinsamen Eckpunkt der Quadrate 8a, 8b und 8c angeordnet.

Die aus dem Bondpad 4 und den Kontaktstegen 2, 3 gebildete Kontaktstruktur bewirkt einerseits eine weitgehend homogene laterale Stromverteilung in der aktiven Schicht 15, wobei nur einen derart geringer Teil der Strahlungsaustrittsfläche 1 von der Kontaktstruktur 2, 3, 4 bedeckt ist, dass nur eine vergleichsweise geringe Absorption der aus der aktiven Schicht 15 in die Hauptstrahlungsrichtung 24 emittierten Strahlung 23 innerhalb der Kontaktstruktur 2, 3, 4 erfolgt. Vorteilhaft wird zumindest ein Teilbereich 11 der Strahlungsaustrittsfläche 1 von den Kontaktstegen 2, 3 umschlossen. Zum Beispiel wird, wie in der Aufsicht in Figur 1A zu erkennen ist, ein Teilbereich 11 der Strahlungsaustrittsfläche 1 von den Kontaktstegen 2, 3 umschlossen, der in diesem Fall innerhalb eines äußeren Quadrats 8c angeordnet ist. Die Fläche des Teilbereichs 11 umfasst also die Fläche des äußeren Quadrats 8c einschließlich der darin angeordneten inneren Quadrate 8a, 8b. Bei einer bevorzugten Ausführungsform werden mehr als 50%, besonders bevorzugt sogar mehr als 80% der Strahlungsaustrittsfläche 1 von den Kontaktstegen 2, 3 umschlossen.

Bei einer weiteren bevorzugten Ausführungsform weist zumindest einer der Kontaktstege eine variable Breite auf. Die Breite dieses Kontaktstegs ist in seiner Haupterstreckungsrichtung nicht konstant, sondern variiert schrittweise oder kontinuierlich. Bei dem in Figur 1 dargestellten Ausführungsbeispiel sind zum Beispiel die beiden vom Bondpad 4 ausgehenden Kontaktstege 3 jeweils aus drei Teilbereichen 5, 6, 7 zusammengesetzt, die jeweils verschiedene Breiten aufweisen. Die Breiten der Kontaktstege 3 in den Teilbereichen 5, 6, 7 sind vorteilhaft jeweils an eine Stromstärke, die beim Betrieb des Lumineszenzdiodenchips durch den jeweiligen Teilbereich 5, 6, 7 auftritt, angepasst. Die Anpassung der Breiten der Teilbereiche 5, 6, 7 an die beim Betrieb auftretenden Stromstärken erfolgt vorzugsweise derart, dass die Querschnittsfläche der Kontaktstege derart dimensioniert ist, dass die bei Betrieb auftretende Stromdichte einen materialabhängigen zulässigen Grenzwert nicht überschreitet, wobei andererseits die Querschnittsfläche aber zumindest nicht wesentlich größer ist als durch die jeweilige Stromstärke bedingt, um unnötige Absorptionsverluste in den Kontaktstegen zu vermeiden. Beispielsweise ist die Stromstärke in den an das Bondpad angrenzenden Teilbereichen 5 der Kontaktstege 3 größer als in dem angrenzenden Teilbereichen 6 und in den Teilbereichen 6 wiederum größer als in dem angrenzenden Teilbereichen 7. Folglich ist die Breite der Kontaktstege 3 in den Teilbereichen 5 größer als in den Teilbereichen 6 und in den Teilbereichen 6 größer als in den Teilbereichen 7.

Auf den von den Kontaktstegen 2, 3 umschlossenen Teilbereich 11 der Strahlungsaustrittsfläche 1 ist bei einer bevorzugten Ausführungsform eine Lumineszenzkonversionsschicht 12 aufgebracht. Die Lumineszenzkonversionsschicht 12 ist beispielsweise eine Silikonschicht, in die zumindest ein Lumineszenzkonversionsstoff eingebettet ist. Bei dem mindestens einen Lumineszenzkonversionsstoff kann es sich beispielsweise um YAG:Ce oder einen anderen aus der WO98/12757 bekannten Lumineszenzkonversionsstoff handeln.

Mittels des Lumineszenzkonversionsstoffs wird beispielsweise die Wellenlänge zumindest eines Teils der aus der aktiven Schicht 15 emittierten Strahlung 23, die beispielsweise grünes, blaues oder ultraviolettes Licht ist, derart in einen komplementären Spektralbereich konvertiert, dass Weißlicht entsteht. Die Verwendung einer Silikonschicht als Trägerschicht für den Lumineszenzkonversionsstoff hat den Vorteil, dass Silikon vergleichsweise unempfindlich gegen kurzwellige blaue oder ultraviolette Strahlung ist. Dies ist insbesondere vorteilhaft für auf Nitridverbindungshalbleitern basierende Lumineszenzdiodenchips, bei denen die emittierte Strahlung in der Regel zumindest einen Anteil aus dem kurzwelligen blauen oder ultravioletten Spektralbereich enthält. Alternativ kann auch ein andere transparentes organisches oder anorganisches Material als Trägerschicht für den mindestens einen Lumineszenzkonversionsstoff fungieren.

Die Lumineszenzkonversionsschicht 12, die vorteilhaft innerhalb eines von den Kontaktstegen 2, 3 umrahmten Teilbereich 11 auf die Strahlungsaustrittsfläche 1 aufgebracht ist, grenzt insbesondere nicht an eine der Seitenflanken 9, 10 des Lumineszenzdiodenchips an. Dadurch wird insbesondere die Gefahr vermindert, dass beim Aufbringen der Lumineszenzkonversionsschicht 12 das Material der Lumineszenzkonversionsschicht auch auf die Seitenflanken 9, 10 abgeschieden wird. Eine Abscheidung des Materials der Lumineszenzkonversionsschicht 12 auf die Seitenflanken 9, 10 hätte insbesondere den Nachteil, dass eine Qualitätskontrolle eines fertig prozessierten Lumineszenzdiodenchips, die in der Regel durch eine mikroskopische Untersuchung einer der Seitenflanken 9, 10 des Lumineszenzdiodenchips erfolgt, erschwert oder sogar unmöglich gemacht würde.

Die Lumineszenzkonversionsschicht 12 ist beispielsweise mit einem Druckverfahren, insbesondere mit einem Siebdruckverfahren, auf den Teilbereich 11 der Strahlungsaustrittsfläche 1 aufgebracht. Die Dicke der Lumineszenzkonversionsschicht 12 beträgt typischerweise etwa 10 µm bis 20 µm.

An die dem Träger 21 zugewandte Hauptfläche 18 der Halbleiterschichtenfolge 13 des Lumineszenzdiodenchips grenzt eine vorteilhaft eine Kontaktschicht 17, die bevorzugt einen ohmschen Kontakt zur angrenzenden Halbleiterschicht 6 herstellt, an. Die Kontaktschicht 17 enthält vorzugsweise ein Metall wie zum Beispiel Aluminium, Silber oder Gold. Im Fall einer p-leitenden an die zweite Kontaktschicht 5 angrenzenden Nitridverbindungshalbleiterschicht 16 ist insbesondere Silber ein geeignetes Material für die Kontaktschicht 17, da Silber einen guten ohmschen Kontakt zu p-leitenden Nitridverbindungshalbleitern herstellt.

Vorzugsweise ist die Kontaktschicht 17 eine die emittierte Strahlung 23 reflektierende Schicht. Dies hat den Vorteil, dass elektromagnetische Strahlung, die von der aktiven Schicht 15 in Richtung des Trägers 21 emittiert wird, zumindest zum Teil zur Strahlungsaustrittsfläche 1 hin reflektiert und dort aus dem Lumineszenzdiodenchip ausgekoppelt wird. Auf diese Weise werden Absorptionsverluste, die beispielsweise innerhalb des Trägers 21 oder in der Verbindungsschicht 20 auftreten könnten, vermindert.

Ein dem Bondpad 4 gegenüber liegender Bereich der Hauptfläche 18 ist bevorzugt von der Kontaktschicht 17 ausgespart. Da in dem ausgesparten Bereich kein ohmscher Kontakt zwischen der Kontaktschicht 17 und der angrenzenden Halbleiterschicht 16 entsteht, wird der Stromfluss zwischen der Kontaktstruktur 2, 3, 4 auf der Strahlungsaustrittsfläche 1 und der elektrischen Kontaktschicht 22 auf der Rückseite des Trägers 21 in dem Bereich der Halbleiterschichtenfolge 13, der in lateraler Richtung zur Kontaktschicht 17 versetzt ist, vermindert. Die Strahlungserzeugung in diesem Bereich der aktiven Schicht 15 ist somit vermindert, wodurch vorteilhaft die Absorption von Strahlung innerhalb des Bondpads 4 reduziert wird.

Zwischen der reflektierenden Kontaktschicht 17 und der Verbindungsschicht 20 ist vorzugsweise eine Barriereschicht 19 enthalten. Die Barriereschicht 19 enthält beispielsweise TiWN. Durch die Barriereschicht 19 wird insbesondere eine Diffusion von Material der Verbindungsschicht 20, die beispielsweise eine Lotschicht ist, in die reflektierende Kontaktschicht 17 verhindert, durch die insbesondere die Reflektion der reflektierenden Kontaktschicht 17 beeinträchtigt werden könnte.

Ein von der aktiven Schicht 15 aus gesehen der Lumineszenzkonversionsschicht 12 gegenüberliegender Bereich der Hauptfläche 18 der Halbleiterschichtenfolge 13, die der Kontaktstruktur 2, 3 ,4 gegenüberliegt, ist vorteilhaft von der reflektierenden Kontaktschicht 17 ausgespart. Auf diese Weise wird die Erzeugung von Strahlung in den Bereichen der aktiven Schicht 15, die in lateraler Richtung versetzt zu der auf der Strahlungsaustrittsfläche angeordneten Lumineszenzkonversionsschicht 12 angeordnet sind, vermindert. Weiterhin wird so der Anteil der emittierten Strahlung, der von der reflektierenden Kontaktschicht 17 in den nicht mit der Lumineszenzkonversionsschicht 12 versehenen Teilbereich der Strahlungsaustrittsfläche 1 reflektiert wird, vermindert.

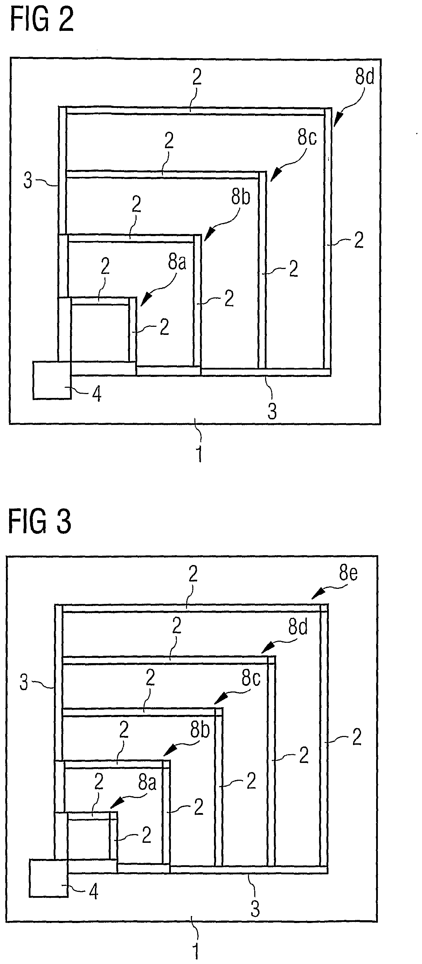

Alternative Ausgestaltungen der auf die Strahlungsaustrittsfläche 1 aufgebrachten Kontaktstruktur, die das Bondpad 4 und die Kontaktstege 2, 3 umfasst, werden im folgenden anhand der in den Figuren 2 bis 8 dargestellten Ausführungsbeispiele erläutert. Dabei ist jeweils nur die Aufsicht auf die Strahlungsaustrittsfläche 1 des Lumineszenzdiodenchips gezeigt. Im Querschnitt können die jeweiligen Lumineszenzdiodenchips beispielsweise gleich aufgebaut sein wie das in Figur 1B im Querschnitt dargestellte erste Ausführungsbeispiel. Weiterhin kann der Lumineszenzdiodenchip aber auch eine beliebige andere dem Fachmann bekannte Ausführungsform aufweisen. Insbesondere muss es sich bei dem Lumineszenzdiodenchip nicht notwendigerweise um einen Dünnfilm-Lumineszenzdiodenchip handeln.

Die in den Figuren 2 und 3 dargestellten Kontaktstrukturen unterscheiden sich von der in Figur 1A dargestellten Kontaktstruktur des ersten Beispiels dadurch, dass die Anzahl der Quadrate, deren Umriss durch die Kontaktstege 2, 3 ausgebildet wird, erhöht wurde.

Bei der in der Figur 2 dargestellten Kontaktstruktur bilden die Kontaktstege 2, 3 vier ineinander geschachtelte Quadrate 8a, 8b, 8c, 8d aus. Wie bei dem ersten Beispiel weisen die ineinander geschachtelten Quadrate jeweils zwei gemeinsame Seitenkanten 3 auf, und das Bondpad 4 ist in einem gemeinsamen Eckpunkt der Quadrate 8a, 8b, 8c, 8d angeordnet.

Bei dem in Figur 3 dargestellten Beispiel umfasst die Kontaktstruktur fünf ineinander geschachtelte Quadrate 8a, 8b, 8c, 8d, 8e. Die Anzahl der erforderlichen Kontaktstege 2, 3 hängt insbesondere von der Größe der Strahlungsaustrittsfläche 1 und der Querleitfähigkeit des darunter liegenden Halbleitermaterials ab.

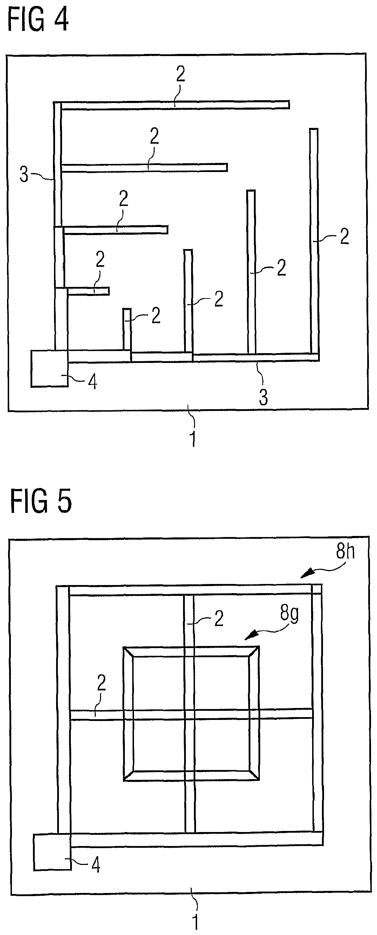

Die aus den Kontaktstegen 2, 3 gebildeten Strukturen auf der Strahlungsaustrittsfläche 1 müssen nicht notwendigerweise in sich geschlossene geometrische Strukturen darstellen. Beispielsweise sind bei dem in der Figur 4 dargestellten Beispiel ausgehend von zwei vom Bondpad ausgehenden Kontaktstegen 3, die eine variable Breite aufweisen, mehrere weitere Kontaktstege 2 fingerförmig über die Strahlungsaustrittsfläche geführt, die aber nicht zu Quadraten miteinander verbunden sind.

Das in Figur 5 dargestellte Beispiel einer Kontaktstruktur unterscheidet sich von den zuvor beschriebenen Beispielen dadurch, dass die Kontaktstruktur nicht aus ineinander geschachtelten Quadraten, die zwei gemeinsame Seitenkanten aufweisen, sondern von zwei konzentrischen Quadraten 8g, 8h, die durch zwei durch das Zentrum der Quadrate 8g, 8h verlaufende Kontaktstege 2 elektrisch leitend miteinander verbunden sind.

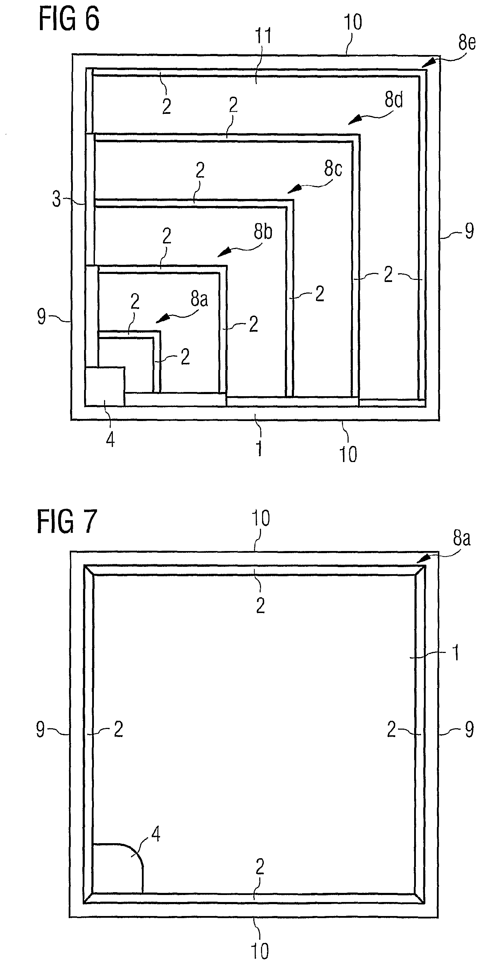

Bei dem in Figur 6 dargestellten Beispiel ist die Kontaktstruktur wie bei dem in Figur 3 dargestellten Beispiel aus fünf ineinander geschachtelten Quadraten 8a, 8b, 8c, 8d, 8e gebildet, die jeweils zwei durch Kontaktstege 3, die eine variable Breite aufweisen, ausgebildete gemeinsame Seitenflanken aufweisen. Das Bondpad 4 ist bei dem in Figur 6 dargestellten Beispiel im Gegensatz zu dem in Figur 3 dargestellten Beispiel derart an einem gemeinsamen Eckpunkt der von der Kontaktstegen 2, 3 ausgebildeten Quadrate 8a, 8b, 8c, 8d ,8e angeordnet, dass es vollständig innerhalb der von den Kontaktstegen ausgebildeten Quadrate angeordnet ist. Das Bondpad 4 weist die Form eines Quadrats auf, bei dem zwei Seitenflanken jeweils mit den zwei gemeinsamen Seitenflanken der von den Kontaktstegen ausgebildeten Quadrate 8a, 8b, 8c, 8d, 8e übereinstimmen. Bei dieser Ausführungsform ist der Abstand der Kontaktstege, die das äußere Quadrat 8e ausbilden, zu den Seitenflanken 9, 10 des Lumineszenzdiodenchips vergleichsweise gering. Insbesondere kann der von dem äußeren Quadrat 8a umschlossene Teilbereich 11 der Strahlungsaustrittsfläche 1 mehr als 80 % der Strahlungsaustrittsfläche 1 umfassen. Dies ist insbesondere vorteilhaft, wenn eine Lumineszenzkonversionsschicht auf den Teilbereich 11 der Strahlungsaustrittsfläche 1 aufgebracht ist, da auf diese Weise nahezu die gesamte Strahlungsaustrittsfläche 1 zur Erzeugung von Weißlicht mit Lumineszenzkonversion ausgenutzt werden kann.

Bei dem in Figur 7 dargestellten Beispiel sind im Vergleich zu dem in Figur 6 dargestellten Beispiel keine innerhalb des Quadrats 8a angeordnete Kontaktstege vorgesehen. Die Kontaktstruktur wird in diesem Fall allein durch das Bondpad 4 und die Kontaktstege 2, die in einem geringen Abstand, vorzugsweise von weniger als 30 µm, entlang der Seitenflanken 9, 10 des Lumineszenzdiodenchips über die Strahlungsaustrittsfläche 1 geführt sind, ausgebildet. Das Bondpad 4 muss nicht notwendigerweise, wie in den zuvor dargestellten Ausführungsbeispielen, eine quadratische Form aufweisen. Vielmehr kann es, wie beispielsweise in Figur 7 dargestellt ist, eine abgerundete Ecke oder auch eine andere geometrische Form aufweisen.

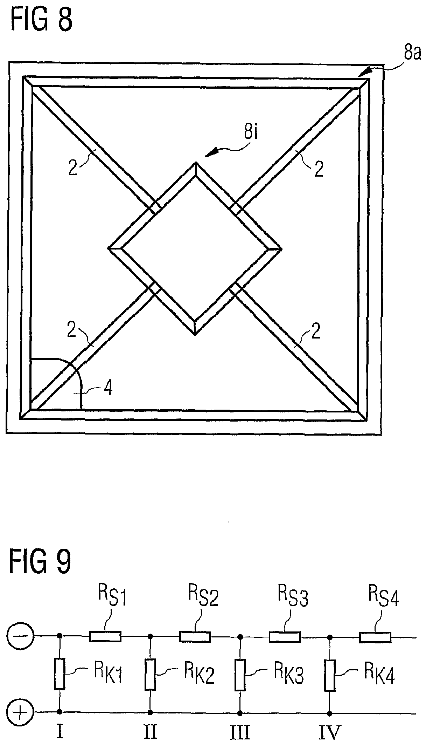

Das in Figur 8 dargestellte Beispiel einer Kontaktstruktur entspricht im wesentlichen dem in Figur 7 dargestellten Beispiel, wobei zusätzlich in einem zentralen Bereich der Strahlungsaustrittsfläche 1 ein inneres Quadrat 8i durch vier Kontaktstege ausgebildet wird, die jeweils mit Verbindungsstegen mit den Eckpunkten eines äußeren Quadrats 8a verbunden sind. Dieses Beispiel verdeutlicht, dass bei der aus mehreren Kontaktstegen gebildeten Kontaktstruktur die Kontaktstege nicht notwendigerweise senkrecht zueinander verlaufen müssen. Vielmehr können mehrere Kontaktstege auch beliebige andere Winkel, beispielsweise 45°-Winkel, miteinander einschließen. Alternativ ist es auch denkbar, dass die Kontaktstege gekrümmte geometrische Formen, beispielsweise Kreise, ausbilden.

Die in Figur 9 gezeigte Ersatzschaltung weist eine Serienschaltung von Widerständen R_{S1} bis R_{S4} auf, wobei R_{S1} mit einem negativen Bezugspotential verbunden ist. Die Knotenpunkte dieser Schaltung sind jeweils über einen Widerstand Rₖ₁ bis Rₖ₄ mit einem positiven Bezugspotential verbunden. Hierbei kann das negative Bezugspotential dem Bondpad und das positive Bezugspotential der Kontaktschicht 22 (s. Figur 1B) entsprechen. Die Serienschaltung der Widerstände R_{S1} bis R_{S4} gibt im Wesentlichen die laterale Stromverteilung in der n-leitenden Halbleiterschicht 14 (s. Figur 1B) wieder, während der vertikale Stromfluss im Chip durch die Widerstände R_{K1} bis R_{K4} modelliert wird.

Den folgenden Betrachtungen liegt das Ziel zugrunde, mittels einer geeigneten Wahl der Widerstände R_{S1} bis R_{S4} und R_{K1} bis R_{K4} eine homogene Stromverteilung im Chip zu erzielen.

Dazu werden die Gesamtwiderstände R_{II}, und R_{IV} an den beiden Knotenpunkten II und IV miteinander verglichen. Die Gesamtwiderstände R_{II}, und R_{IV} sind eine Summe der Einzelwiderstände entlang der verschiedenen Strompfade. Somit ist R_{II}, = R_{S1} + R_{K2} und R_{IV} = R_{S1} + R_{S2} + R_{S3} + R_{K4}.

Sowohl die Widerstände R_{S1} bis R_{S4} als auch die Widerstände R_{K1} bis R_{K4} hängen von der Breite der Kontaktstege ab. Im Folgenden werden verschiedene Breiten untersucht:

### A) Kontaktstegbreite b

Weist der Kontaktsteg eine gleich bleibende Breite b auf, so gilt: R_{S1} = R_{S2} = R_{S3} = R_{S4} = R_{S} und R_{K1} = R_{K2} = R_{K3} = R_{K4} = Rₖ. Daraus folgt für die Widerstände R_{II}, und R_{IV}: R_{II}, = R_{S} + R_{K} und R_{IV} = 3R_{S} + R_{K}.

### B) Kontaktstegbreite 2b

Weist der Kontaktsteg eine gleich bleibende Breite 2b auf, so gilt: R_{S1} = R_{S2} = R_{S3} = R_{S4} = 0.5 R_{S} und R_{K1} = R_{K2} = R_{K3} = R_{K4} = 0.5 Rₖ. Daraus folgt für die Widerstände R_{II}, und R_{IV}: R_{II} = 0.5 R_{S} + 0.5 R_{K} und R_{IV} = 3*0.5 R_{S} + 0.5 R_{K}.

### C) Abnehmende Kontaktstegbreite

Der Kontaktsteg weist einen Teilbereich der Kontaktstegbreite 2b und einen Teilbereich der Kontaktstegbreite b auf, so dass gilt: R_{S1} = R_{S2} = 0.5 R_{S} und R_{S3} = R_{S4} = R_{S} (Kontaktstegbreite b) und R_{K1} = R_{K2} = 0.5 R_{K} (Kontaktstegbreite 2b) und R_{K3} = R_{K4} = R_{K} (Kontaktstegbreite b). Daraus folgt für die Widerstände R_{II}, und R_{IV}: R_{II}, = 0. 5 R_{S} + 0.5 R_{K} und R_{IV} = 2*0.5 R_{S} + R_{S} + R_{K}.

### D) Zunehmende Kontaktstegbreite

Der Kontaktsteg weist einen Teilbereich der Breite b und einen Teilbereich der Breite 2b auf, so dass gilt: R_{S1} = R_{S2} = R_{S} (Kontaktstegbreite b) und R_{S3} = R_{S4} = 0.5 R_{S} (Kontaktstegbreite 2b) und R_{K1} = R_{K2} = R_{K} (Kontaktstegbreite b) und R_{K3} = R_{K4} = 0.5 R_{K} (Kontaktstegbreite 2b) . Daraus folgt für die Widerstände R_{II}, und R_{IV}: R_{II} = R_{S} + R_{K} und R_{IV} = 2R_{S} + 0.5 R_{S} + 0.5 R_{K}.

Gilt R_{S} = R_{K}, so ergibt im Falle von A) R_{II}/R_{IV} = 1/2, im Falle von B) R_{II}/R_{IV} = 1/2, im Falle von C) R_{II}/R_{IV} = 1/3 und im Falle von D) R_{II}/R_{IV} = 2/3.

Gilt R_{S} >> R_{K}, so ergibt im Falle von A) R_{II}/R_{IV} = 1/3, im Falle von B) R_{II}/R_{IV} = 1/3, im Falle von C) R_{II}/R_{IV} = 1/4 und im Falle von D) R_{II}/R_{IV} = 2/5.

Gilt R_{S} << R_{K}, so ergibt im Falle von A) R_{II}/R_{IV} = 1, im Falle von B) R_{II}/R_{IV} = 1, im Falle von C) R_{II}/R_{IV} = 1/2 und im Falle von D) R_{II}/R_{IV} = 2.

Für eine homogene Stromverteilung wird ein Verhältnis R_{II}/R_{IV} = 1 bevorzugt. Denn im Falle von R_{II}/R_{IV} > 1 tritt weiter entfernt vom Bondpad eine höhere Leuchtdichte auf, während im Falle von R_{II}/R_{IV} < 1 am Bondpad eine höhere Leuchtdichte auftritt, was beides nicht favorisiert wird. Somit ist für R_{S} = R_{K} und R_{S} >> R_{K} die Variante D), das bedeutet eine ausgehend vom Bondpad zunehmende Kontaktstegbreite, die bevorzugte Ausgestaltung. Im Falle von R_{S} = R_{K} und R_{S} >> R_{K} ist die Leitfähigkeit des Kontaktstegs begrenzt.

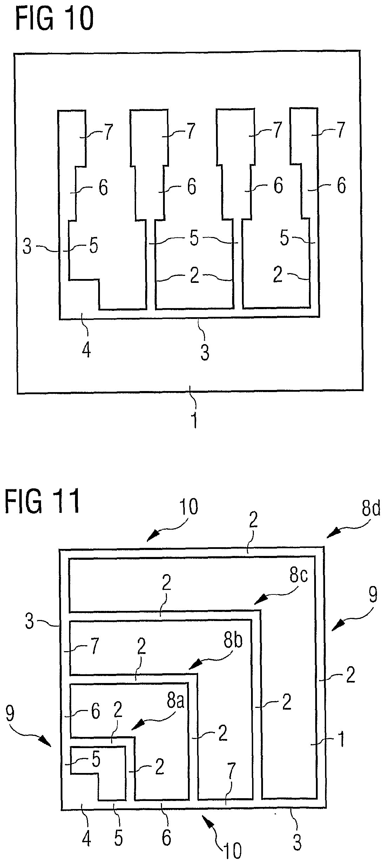

Der in Figur 10 in einer Aufsicht dargestellte Lumineszenzdiodenchip gemäß einem Ausführungsbeispiel der Erfindung weist auf der Strahlungsaustrittsfläche 1 eine Kontaktstruktur bestehend aus Bondpad 4 und Kontaktstegen 2, 3 auf. Die Kontaktstege 2 und zumindest einer der Kontaktstege 3 weisen eine zunehmende Kontaktstegbreite auf, was gemäß der oben stehenden Ausführungen favorisiert wird. Mittels einer derartigen Wahl der Kontaktstegbreite kann eine vergleichsweise homogene Stromverteilung über die Strahlungsaustrittsfläche 1 hinweg erzielt werden.

Die Kontaktstege 2 und zumindest einer der Kontaktstege 3 weisen Teilbereiche 5, 6 und 7 auf, wobei der Teilbereich 5 breiter ist als der Teilbereich 7.

Neben der dargestellten gabelförmigen Struktur der Kontaktstege 2, 3 sind ferner Ausgestaltungen denkbar, bei denen beispielsweise ein weiterer Kontaktsteg die getrennten Teilbereiche 7 verbindet. Desweiteren ist denkbar, dass der Kontaktsteg 3, von welchem die Kontaktstege 2 abzweigen, ebenfalls in die Teilbereiche 5, 6 und 7 unterteilt ist.

In Figur 11 ist eine Aufsicht auf ein weiteres Beispiel eines Lumineszenzdiodenchips dargestellt.

Das Bondpad 4 der auf der Strahlungsaustrittsfläche 1 angeordneten Kontaktstruktur ist in einer Ecke der Strahlungsaustrittsfläche 1 angeordnet. Bevorzugt fallen zwei Seitenkanten des Bondpads 4 mit zwei Seitenkanten 9 und 10 des Chips zusammen. Entlang der Seitenkanten 9 und 10 erstrecken sich besonders bevorzugt die Kontaktstege 3. Dies hat den Vorteil, dass der Randbereich nicht ungenutzt bleibt, sondern zur Stromaufweitung dient. Die Kontaktstege 3 bilden mit den Kontaktstegen 2 den Umriss mehrerer Quadrate 8a, 8b, 8c, 8d aus.

Anhand der Figuren 12A und 12B soll im Folgenden erläutert werden, weshalb die Anforderungen an die Justagegenauigkeit bei einem Chip mit Eck-Anordnung des Bondpads geringer ist als bei einem Bondpad mit zentraler Anordnung des Bondpads.

Wie in Figur 12A dargestellt, ergibt sich für den Fall einer zentralen Anordnung des Bondpads bei einer tatsächlichen Länge L des Bondpads 4 eine zur Aufbringung erforderliche Länge P_{M} = L + 4d. d ist hierbei die beim Aufbringen der Lumineszenzkonversionsschicht erzielbare Justagegenauigkeit. Hingegen beträgt die zur Aufbringung erforderliche Länge bei einer Eck-Anordnung des Bondpads 4 P_{E} = L + 2d.
Die Anforderungen an die Justagegenauigkeit sind somit bei einer Eck-Anordnung bei gleicher Bondpadgröße um den Faktor 2 verringert.

## Patentansprüche

1. Lumineszenzdiodenchip mit einer Strahlungsaustrittsfläche (1) und einer Kontaktstruktur (2, 3, 4), die auf der Strahlungsaustrittsfläche (1) angeordnet ist und ein Bondpad (4) und mehrere zur Stromaufweitung vorgesehene Kontaktstege (2, 3), die mit dem Bondpad (4) elektrisch leitend verbunden sind, umfasst, wobei der Mittelpunkt des Bondpads (4) einen geringeren Abstand zu zumindest einer Seitenflanke des Lumineszenzdiodenchips als zum Mittelpunkt der Strahlungsaustrittsfläche (1) aufweist, und der Lumineszenzdiodenchip eine Halbleiterschichtenfolge (13) enthält, die eine aktive Schicht (15) umfasst, wobei zumindest einer der Kontaktstege (3) eine variable Breite aufweist, wobei die Breite des Kontaktstegs in seiner Haupterstreckungsrichtung ausgehend vom Bondpad (4) schrittweise oder kontinuierlich zunimmt,
**dadurch gekennzeichnet, dass** weniger als 15% der Strahlungsaustrittsfläche (1) von der Kontaktstruktur (2, 3, 4) bedeckt sind.

2. Lumineszenzdiodenchip nach Anspruch 1,
**dadurch gekennzeichnet, dass**
der Abstand d₁ zwischen dem Bondpad (4) und zumindest einer Seitenflanke (9) des Lumineszenzdiodenchips geringer ist als 30 µm.

3. Lumineszenzdiodenchip nach Anspruch 2,
**dadurch gekennzeichnet, dass**
der Abstand d₂ zwischen dem Bondpad (4) und einer weiteren Seitenflanke (10) des Lumineszenzdiodenchips geringer ist als 30 µm.

4. Lumineszenzdiodenchip nach einem der vorhergehenden Ansprüche,
**dadurch gekennzeichnet, dass**
mindestens ein Kontaktsteg (2, 3) entlang einer Seitenkante (9, 10) verläuft, wobei der Abstand zur Seitenkante (9, 10) geringer ist als 15 µm.

5. Lumineszenzdiodenchip nach Anspruch 4,
**dadurch gekennzeichnet, dass**
der Kontaktsteg (2, 3) an die Seitenkante (9, 10) des Lumineszenzdiodenchips angrenzt.

6. Lumineszenzdiodenchip nach einem der vorhergehenden Ansprüche,
**dadurch gekennzeichnet, dass**
die Kontaktstruktur (2, 3, 4) gabelförmig ausgebildet ist.

7. Lumineszenzdiodenchip nach Anspruch 6,
**dadurch gekennzeichnet, dass**
zwischen den Kontaktstegen (2,3) eine Lumineszenzkonversionsschicht (12) auf der Strahlungsaustrittsfläche (1) aufgebracht ist.

8. Lumineszenzdiodenchip nach einem der vorhergehenden Ansprüche,
**dadurch gekennzeichnet, dass**
die Breite von Teilbereichen (5, 6, 7) des Kontaktstegs (3) an eine beim Betrieb des Lumineszenzdiodenchips durch den jeweiligen Teilbereich (5, 6, 7) auftretende Stromstärke angepasst ist.

9. Lumineszenzdiodenchip nach einem der vorhergehenden Ansprüche,
**dadurch gekennzeichnet, dass**
die Breite der Kontaktstege (2, 3) zwischen einschließlich 10 µm und einschließlich 40 µm beträgt.

10. Lumineszenzdiodenchip nach einem der vorhergehenden Ansprüche,
**dadurch gekennzeichnet, dass**
der Lumineszenzdiodenchip ein Dünnfilm-Lumineszenzdiodenchip ist.

11. Lumineszenzdiodenchip nach einem der vorhergehenden Ansprüche,
**dadurch gekennzeichnet, dass**
der Lumineszenzdiodenchip eine aktive Schicht (15) aufweist, die InₓAl_{y}Ga_{1-x-y}N mit 0 ≤ x ≤ 1, 0 ≤ y ≤ 1 und x + y ≤1, enthält.

12. Lumineszenzdiodenchip nach einem der vorhergehenden Ansprüche,
**dadurch gekennzeichnet, dass**
die Länge zumindest einer Seitenkante (9, 10) der Strahlungsaustrittsfläche (1) 400 µm oder mehr beträgt.

13. Lumineszenzdiodenchip nach Anspruch 12,
**dadurch gekennzeichnet, dass**
die Länge zumindest einer Seitenkante (9, 10) der Strahlungsaustrittsfläche (1) 800 µm oder mehr beträgt.

14. Lumineszenzdiodenchip nach einem der vorhergehenden Ansprüche,
**dadurch gekennzeichnet, dass**
die Kontaktstruktur (2, 3, 4) eine strukturierte Ti-Pt-Au-Schichtenfolge ist.

15. Lumineszenzdiodenchip nach Anspruch 14,
**dadurch gekennzeichnet, dass**
die Kontaktstruktur (2, 3, 4) die vom Chip erzeugte Strahlung absorbiert.

16. Lumineszenzdiodenchip nach einem der vorhergehenden Ansprüche,
**dadurch gekennzeichnet, dass**
die Kontaktstruktur (2, 3, 4) frei von Aluminium ist.

17. Lumineszenzdiodenchip nach einem der vorhergehenden Ansprüche,
**dadurch gekennzeichnet, dass**
an einer der Strahlungsaustrittsfläche (1) gegenüberliegenden Hauptfläche (18) der Halbleiterschichtenfolge (13) eine reflektierende Kontaktschicht (17) vorgesehen ist, wobei ein dem Bondpad (4) gegenüberliegender Bereich der Hauptfläche (18) von der Kontaktschicht (17) ausgespart ist.

18. Lumineszenzdiodenchip nach Anspruch 17 unter Rückbezug auf Anspruch 7,
**dadurch gekennzeichnet, dass**
ein Bereich der Hauptfläche (18), der von der gegenüberliegenden Lumineszenzkonversionsschicht (12) lateral versetzt ist, von der Kontaktschicht (17) ausgespart ist.

## Claims

1. A luminescence diode chip having a radiation exit area (1) and a contact structure (2, 3, 4) which is arranged on the radiation exit area (1) and comprises a bonding pad (4) and a plurality of contact webs (2, 3) which are provided for current expansion and are electrically conductively connected to the bonding pad (4), wherein a center point (4) of the bonding pad is at a shorter distance from at least one side flank of the luminescence diode chip (1) than from the center point of the radiation exit area, and wherein the luminescence diode chip contains a semiconductor layer sequence (13) which comprises an active layer (15),
wherein at least one of the contact webs (3) has a variable width, wherein the width of the contact web in its main direction of extent increases in a stepwise manner or continuously starting from the bonding pad (4), **characterized in that** less than 15% of the radiation exit area (1) is covered by the contact structure (2, 3, 4).

2. The luminescence diode chip as claimed in claim 1,
wherein
the distance d₁ between the bonding pad (4) and at least one side flank (9) of the luminescence diode chip is less than 30 µm.

3. The luminescence diode chip as claimed in claim 2,
wherein
the distance d₂ between the bonding pad (4) and a further side flank (10) of the luminescence diode chip is less than 30 µm.

4. The luminescence diode chip as claimed in one of the preceding claims,
wherein
at least one contact web (2, 3) runs along a side edge (9, 10), the distance from the side edge (9, 10) being less than 15 µm.

5. The luminescence diode chip as claimed in claim 4,
wherein
the contact web (2, 3) adjoins the side edge (9, 10) of the luminescence diode chip.

6. The luminescence diode chip as claimed in one of the preceding claims,
wherein
the contact structure (2, 3, 4) is in the form of a fork.

7. The luminescence diode chip as claimed in claim 6,
wherein
a luminescence conversion layer (12) is applied to the radiation exit area (1) between the contact webs (2, 3).

8. The luminescence diode chip as claimed in one of the preceding claims,
wherein
the width of the partial regions (5, 6, 7) of the contact web (3) is matched to a current intensity which occurs when the luminescence diode chip is being operated using the respective partial region (5, 6, 7).

9. The luminescence diode chip as claimed in one of the preceding claims,
wherein
the width of the contact webs (2, 3) is between 10 µm and 40 µm inclusive.

10. The luminescence diode chip as claimed in one of preceding claims,
wherein
the luminescence diode chip is a thin-film luminescence diode chip.

11. The luminescence diode chip as claimed in one of the preceding claims,
wherein
the luminescence diode chip has an active layer (15) containing InₓAl_{y}Ga_{1-x-y}N, where 0 ≤ x ≤ 1, 0 ≤ y ≤ 1 and x + y ≤ 1.

12. The luminescence diode chip as claimed in one of the preceding claims,
wherein
the length of at least one side edge (9, 10) of the radiation exit area (1) is 400 µm or more.

13. The luminescence diode chip as claimed in claim 12,
wherein
the length of at least one side edge (9, 10) of the radiation exit area (1) is 800 µm or more.

14. The luminescence diode chip as claimed in one of the preceding claims,
wherein
the contact structure (2, 3, 4) is a patterned Ti-Pt-Au layer sequence.

15. The luminescence diode chip as claimed in claim 14,
wherein
the contact structure (2, 3, 4) absorbs the radiation generated by the chip.

16. The luminescence diode chip as claimed in one of the preceding claims,
wherein
the contact structure (2, 3, 4) is free of aluminum.

17. The luminescence diode chip as claimed in one of the preceding claims,
wherein
a reflective contact layer (17) is provided on a main area (18) of the semiconductor layer sequence (13) that is opposite the radiation exit area (1), a region of the main area (18) that is opposite the bonding pad (4) being spared from the contact layer (17).

18. The luminescence diode chip as claimed in claim 17 with reference back to claim 7,
wherein
a region of the main area (18) that is laterally displaced from the opposing luminescence conversion layer (12) is spared from the contact layer (17).

## Revendications

1. Puce à diode électroluminescente comprenant une surface de sortie de rayonnement (1) et une structure de contact (2, 3, 4) qui est disposée sur la surface de sortie de rayonnement (1) et comprend un plot de connexion (4) et plusieurs nervures de contact (2, 3) prévues pour l'élargissement de courant, lesquelles sont reliées au plot de connexion(4) de manière électroconductrice, le centre du plot de connexion(4) présentant un écart plus petit par rapport à au moins un flanc latéral de la puce à diode électroluminescente que par rapport au centre de la surface de sortie de rayonnement (1), et la puce à diode électroluminescente contenant une succession de couches semi-conductrices (13), laquelle comprend une couche active (15), au moins une des nervures de contact (3) présentant une largeur variable, la largeur de la nervure de contact, dans sa direction d'étendue principale, augmentant progressivement ou de manière continue en partant du plot de connexion(4), **caractérisée en ce que** moins de 15% de la surface de sortie de rayonnement (1) sont recouverts par la structure de contact (2, 3, 4).

2. Puce à diode électroluminescente selon la revendication 1,
**caractérisée en ce que**
l'écart d₁ entre le plot de connexion (4) et au moins un flanc latéral (9) de la puce à diode électroluminescente est inférieur à 30 µm.

3. Puce à diode électroluminescente selon la revendication 2,
**caractérisée en ce que**
l'écart d₂ entre le plot de connexion (4) et un flanc latéral (10) supplémentaire de la puce à diode électroluminescente est inférieur à 30 µm.

4. Puce à diode électroluminescente selon l'une quelconque des revendications précédentes,
**caractérisée en ce qu'**
au moins une nervure de contact (2, 3) s'étend le long d'une arête latérale (9, 10), l'écart par rapport à l'arête latérale (9, 10) étant inférieur à 15 µm.

5. Puce à diode électroluminescente selon la revendication 4,
**caractérisée en ce que**
la nervure de contact (2, 3) est adjacente à l'arête latérale (9, 10) de la puce à diode électroluminescente.

6. Puce à diode électroluminescente selon l'une quelconque des revendications précédentes,
**caractérisée en ce que**
la structure de contact (2, 3, 4) est réalisée en forme de fourchette.

7. Puce à diode électroluminescente selon la revendication 6,
**caractérisée en ce qu'**
entre les nervures de contact (2, 3), une couche de conversion de luminescence (12) est appliquée sur la surface de sortie de rayonnement (1).

8. Puce à diode électroluminescente selon l'une quelconque des revendications précédentes,
**caractérisée en ce que**
la largeur de zones partielles (5, 6, 7) de la nervure de contact (3) est adaptée à une intensité de courant se produisant à travers la zone partielle respective (5, 6, 7) pendant le fonctionnement de la puce à diode électroluminescente.

9. Puce à diode électroluminescente selon l'une quelconque des revendications précédentes,
**caractérisée en ce que**
la largeur des nervures de contact (2, 3) est comprise entre, y compris, 10 µm et, y compris, 40 µm.

10. Puce à diode électroluminescente selon l'une quelconque des revendications précédentes,
**caractérisée en ce que**
la puce à diode électroluminescente est une puce à diode électroluminescente à couches minces.

11. Puce à diode électroluminescente selon l'une quelconque des revendications précédentes,
**caractérisée en ce que**
la puce à diode électroluminescente présente une couche active (15) qui contient InₓAl_{y}Ga_{1-x-y}N, où 0 ≤ x ≤ 1, 0 ≤ y ≤ 1 et x + y ≤ 1.

12. Puce à diode électroluminescente selon l'une quelconque des revendications précédentes,
**caractérisée en ce que**
la longueur d'au moins une arête latérale (9, 10) de la surface de sortie de rayonnement (1) est de 400 µm ou plus.

13. Puce à diode électroluminescente selon la revendication 12,
**caractérisée en ce que**
la longueur d'au moins une arête latérale (9, 10) de la surface de sortie de rayonnement (1) est de 800 µm ou plus.

14. Puce à diode électroluminescente selon l'une quelconque des revendications précédentes,
**caractérisée en ce que**
la structure de contact (2, 3, 4) est une succession structurée de couches de Ti Pt Au.

15. Puce à diode électroluminescente selon la revendication 14,
**caractérisée en ce que**
la structure de contact (2, 3, 4) absorbe le rayonnement généré par la puce.

16. Puce à diode électroluminescente selon l'une quelconque des revendications précédentes,
**caractérisée en ce que**
la structure de contact (2, 3, 4) est exempte d'aluminium.

17. Puce à diode électroluminescente selon l'une quelconque des revendications précédentes,
**caractérisée en ce qu'**
une couche de contact (17) réfléchissante est prévue sur une surface principale (18) de la succession de couches semi-conductrices (13), opposée à la surface de sortie de rayonnement (1), une zone de la surface principale (18), opposée au plot de connexion (4), étant dépourvue de la couche de contact (17).

18. Puce à diode électroluminescente selon la revendication 17 avec renvoi à la revendication 7,
**caractérisée en ce qu'**
une zone de la surface principale (18), laquelle est latéralement décalée de la couche de conversion de luminescence (12) opposée, est dépourvue de la couche de contact (17).
